# EUROPEAN PATENT SPECIFICATION

(11) **EP 1 535 332 B1**
(45) Date of publication and mention of the grant of the patent: **11.04.2012**
(21) Application number: 03791994.1
(22) Date of filing: 29.08.2003
(51) Int. Cl.: H01L 27/06, H01L 27/08, H01L 21/02

(54) **SEMICONDUCTOR DEVICE INCLUDING A FIELD EFFECT TRANSISTOR AND A PASSIVE CAPACITOR HAVING REDUCED LEAKAGE CURRENT AND AN IMPROVED CAPACITANCE PER UNIT AREA**
HALBLEITERANORDNUNG MIT EINEM FELDEFFEKT-TRANSISTOR UND EINEM PASSIVEN KONDENSATOR, DER EINEN VERRINGERTEN LECKSTROM UND EINE VERBESSERTE KAPAZITÄT PRO FLÄCHENEINHEIT AUFWEIST
DISPOSITIF A SEMI-CONDUCTEURS COMPRENANT UN TRANSISTOR A EFFET DE CHAMP AINSI QU'UN CONDENSATEUR PASSIF A COURANT DE FUITE REDUIT ET CAPACITE ACCRUE PAR UNITE DE SURFACE

(30) Priority: 02.09.2002 DE 10240423; 31.03.2003 US 403481
(43) Date of publication of application: 01.06.2005
(73) Proprietor: ADVANCED MICRO DEVICES, INC., Sunnyvale CA 94088-3453 (US)
(72) Inventor: WIECZOREK, Karsten, 01109 Dresden (DE); BURBACH, Gert, 01109 Dresden (DE); FEUDEL, Thomas, 01445 Radebeul (DE)
(74) Representative: Grünecker, Kinkeldey, Stockmair & Schwanhäusser
(86) International application number: PCT/US2003/027367
(87) International publication number: WO 2004/021440

(56) References cited:
- EP-A- 1 049 173
- US-A- 6 057 572
- US-A- 6 064 102
- US-A- 6 093 616
- US-A- 2002 048 885
- US-A1- 2002 022 334
- US-A1- 2002 066 916
- US-A1- 2002 093 781
- PATENT ABSTRACTS OF JAPAN vol. 007, no. 072 (E-166), 25 March 1983 (1983-03-25) -& JP 58 002071 A (MITSUBISHI DENKI KK), 7 January 1983 (1983-01-07)
- PATENT ABSTRACTS OF JAPAN vol. 013, no. 541 (E-854), 5 December 1989 (1989-12-05) -& JP 01 222469 A (FUJITSU LTD), 5 September 1989 (1989-09-05)

## Description

### TECHNICAL FIELD

The present invention generally relates to the field of fabricating integrated circuits, and, more particularly, to the formation of semiconductor devices including field effect transistors, such as MOS transistors, and passive capacitors having a reduced leakage current.

### BACKGROUND ART

In modern integrated circuits, a huge number of individual circuit elements, such as field effect transistors in the form of CMOS, NMOS, PMOS elements, resistors, capacitors, and the like, are formed on a single chip area. Typically, feature sizes of these circuit elements are steadily decreasing with the introduction of every new circuit generation, to provide currently available integrated circuits with an improved degree of performance in terms of speed and power consumption. A reduction in size of transistor is an important aspect in steadily improving device performance of complex integrated circuits, such as CPUs, as the reduction in size commonly brings about an increased switching speed, thereby enhancing signal processing performance and also power consumption, since, due to the reduced switching time period, the transient currents upon switching a CMOS transistor element from logic low to logic high are significantly reduced. On the other hand, the reduction of feature sizes, such as the channel length of the transistor elements in the deep sub-micron regime, entails a plurality of issues that may partially offset the advantages obtained by the improved switching performance. For example, reducing the channel length of field effect transistors requires the reduction of the thickness of the gate insulation layer in order to maintain a sufficiently high capacitive coupling of the gate electrode to the channel region so as to appropriately control the formation of the conductive channel upon application of a control voltage to the gate electrode. For highly sophisticated devices, currently featuring a channel length of 0.18 µm or even less, typically comprising silicon dioxide for the superior and well known characteristics of the interface between the silicon dioxide and the underlying channel region, a thickness of the gate insulation layer is on the order of 2-5 nm or even less. For a gate dielectric of this order of magnitude, it turns out that, in total, the leakage current passing through the thin gate dielectric may become comparable to the transient currents, since the leakage currents exponentially rise as the gate dielectric thickness is linearly reduced.

In addition to the large number of transistor elements, plural passive capacitors are typically formed in integrated circuits that are used for a plurality of purposes, such as for de-coupling purposes. Since these capacitors are usually formed in and on active semiconductor regions, acting as a first capacitor electrode, with a dielectric layer having characteristics in conformity with process requirements for the concurrently fabricated field effect transistors, and a second capacitor electrode formed of the gate electrode material, the problem of leakage current is significantly exacerbated owing to the large chip area occupied by these capacitor elements. Consequently, the capacitors significantly contribute to the total gate leakage consumption and, therefore, to the total power consumption of the integrated circuit. For applications requiring a minimum power consumption, such as portable battery-powered devices, the high amount of static power consumption may not be acceptable, and, therefore, usually a so-called dual gate oxide processing may be used to increase the thickness of the dielectric layer of the capacitors, thereby reducing the leakage current of these elements.

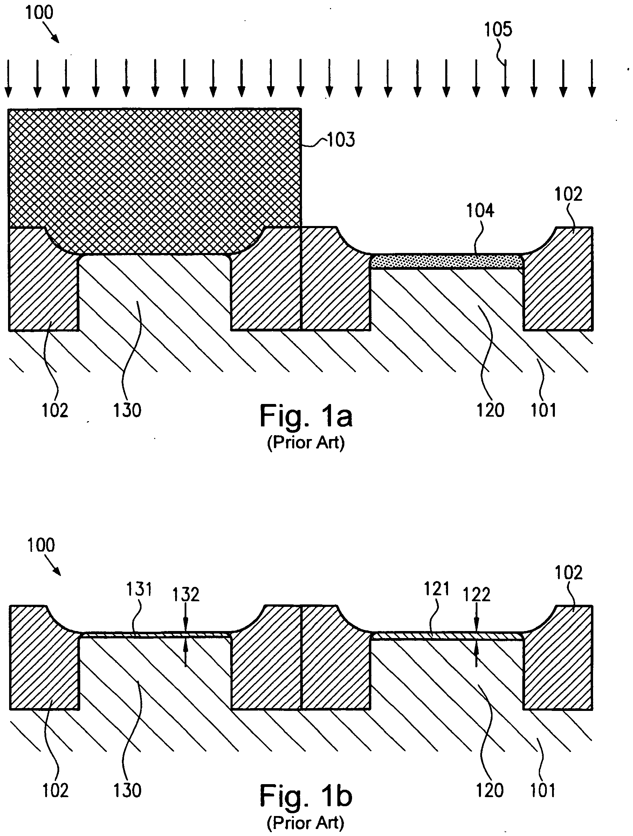

With reference to Figures 1a-1c, a typical prior art process flow for forming capacitors having a reduced leakage current will now be described. Fig. 1a schematically shows a cross-sectional view of a semiconductor device 100 at an initial manufacturing stage. The semiconductor device 100 comprises a substrate 101, for example a silicon substrate, including a first active semiconductor region 120 and a second active semiconductor region 130, which are enclosed by respective isolation structures 102. The second active region 130 and the corresponding isolation structure 102 are covered by a mask layer 103 that may be comprised of photoresist. The first active region 120 comprises a surface portion 104 having severe lattice damage caused by an ion implantation, as indicated by 105.

A typical process flow for forming the semiconductor device as depicted in Figure 1a includes sophisticated photolithography and etch techniques for defining the isolation structures 102 followed by a further photolithography step to pattern the resist mask 103. As these process techniques are well known in the art, a detailed description thereof is omitted. Subsequently, the ion implantation 105 is carried out with any appropriate ions, such as silicon, argon, xenon and the like, wherein a dose and energy is selected to create severe lattice damage in the portion 104, thereby significantly changing the diffusion behavior of the portion 104 during an oxidation process that is to be carried out subsequently.

Figure 1b schematically shows the semiconductor structure 100 in an advanced manufacturing stage. A first dielectric layer 121, substantially comprised of silicon dioxide, and having a first thickness 122, is formed on the first active region 120. A second dielectric layer 131 having a second thickness 132 and comprised of the same material as the first dielectric layer 121 is formed on the second active region 130. The first and the second dielectric layers 121 and 131 are formed by conventional oxidation in a high temperature furnace process or by a rapid thermal oxidation process. Due to the severe lattice damage of the surface portion 104, the oxygen diffusion in this surface portion 104 is significantly enhanced compared to silicon portions having a substantially intact crystallinity, such as in the second active region 130. Consequently, oxide growth in and on the first active region 120 is increased compared to the growth rate of the second active region 130 so that the second thickness 132 differs from the first thickness 122 by approximately 0.2-1.0 nm for a thickness of the second dielectric layer 131 on the order of 1-5 nm.

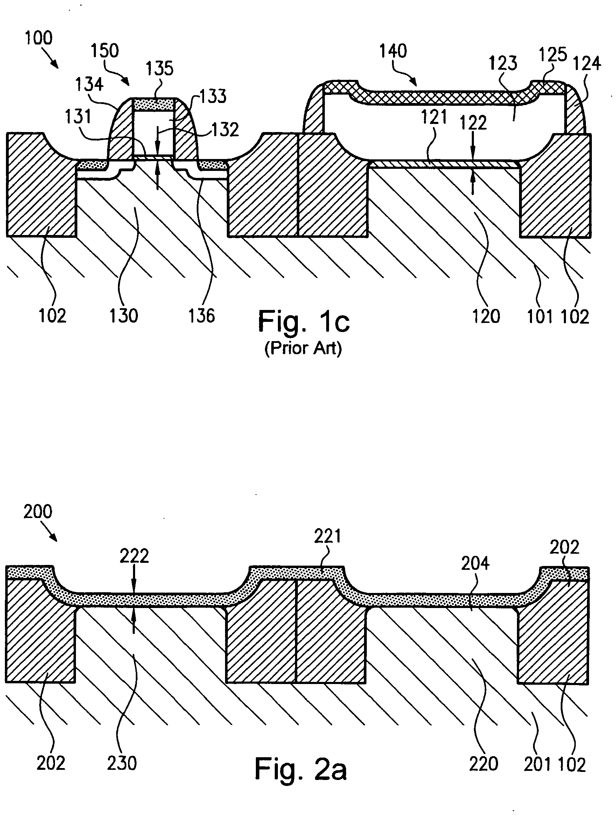

Figure 1c schematically shows the semiconductor device 100 in a further advanced manufacturing stage, wherein a capacitor 140 is formed in and on the first active region 120, and a field effect transistor 150 is formed in and on the second active region 130. The transistor element 150 comprises a gate electrode 133 including, for example, highly doped polysilicon and a metal silicide portion 135. Moreover, sidewall spacers 134 are formed adjacent to sidewalls of the gate electrode 133. Source and drain regions 136, each including a metal silicide portion 135, are formed in the second active region 130. The capacitor 140 comprises a conductive portion 123 comprised of the same material as the gate electrode 133 and is formed over the first dielectric layer 121. The portion 123 represents one electrode of the capacitor 140. The capacitor electrode 123 includes a metal silicide portion 125 and is enclosed by sidewall spacer elements 124.

A typical process flow for forming the transistor element 150 and the capacitor 140 may include the following steps. A polysilicon layer may be deposited over the device as shown in Fig. 1b and is patterned by well known photolithography and etching techniques to create the capacitor electrode 123 and the gate electrode

The prior art documents US2002/0093781, US 6093616 and US 605 75 72 disclose the integration of a field effect MOS transistor and a capacitor.

The prior art document US 606 4102 discloses integration of MOS transistors with different gate insulator permittivities.

The prior art document US 2002/0066916 discloses the integration of capacitors with capacitor insulating layers of different thicknesses. 133. Subsequently, the drain and source region 136 are formed by ion implantation, wherein intermittently the sidewall spacers 134 and the sidewall spacers 124 are formed so that the sidewall spacers 134 may act as implantation masks to appropriately shape the dopant concentration of the drain and source regions 136. Thereafter, the metal silicide portions 125 and 135 are formed by depositing a refractory metal and initiating a chemical reaction between the metal and the underlying polysilicon of the capacitor electrode 123, the gate electrode 133, and the silicon in the drain and source regions 136.

As is evident from Figure 1c, the capacitor 140 having the first dielectric layer 121 with the increased thickness 122 will exhibit a significantly reduced leakage current rate compared to the corresponding leakage rate caused by the relatively thin second dielectric layer 131 having the second thickness 132 that is optimized to provide the required dynamic performance of the transistor 150. Although a remarkably improved leakage rate of the capacitor 140 may be obtained with the above-described conventional approach, one decisive drawback is the significantly reduced capacitance per unit area of the capacitor 140 owing to the increased thickness of the first dielectric layer 121. A further disadvantage of the conventional prior art approach is the requirement of a high temperature oxidation process for forming the first and second dielectric layers 121 and 131 so that this process scheme is not compatible with alternative solutions for forming extremely thin gate dielectrics, such as advanced deposition methods for forming ultra thin gate insulation layers. Moreover, the ion bombardment 105 for forming the surface portion 104 (Figure 1a) may entail a significant oxide degradation and thus may give rise to reliability issues of the first dielectric layer 121, thereby causing premature device failure.

In view of the above-identified problems, there is a need for improved semiconductor devices including transistor elements and passive capacitors, in which leakage current of the capacitors is improved without unduly adversely affecting device characteristics, such as capacitance per unit area, and process compatibility during manufacturing of the device and/or reliability.

### DISCLOSURE OF INVENTION

Generally, the present invention is directed to a semiconductor device and a corresponding manufacturing method as recited in claims 1, 6, 10 and 15 respectively; wherein a passive capacitor includes a dielectric exhibiting a relatively high permittivity so that the capacitance per unit area may significantly be increased while a thickness of the dielectric may be selected appropriately to ensure a low desired leakage rate. At the same time, the gate insulation layer of field effect transistors may be formed in accordance with process requirements and with a material that ensures the required performance of the transistor device. The present invention is, therefore, based on the inventors' concept that although presently the employment of high-k materials for gate dielectrics in field effect transistors has not been successfully implemented, as these materials cause significant transistor degradation owing to the reduced channel mobility caused by these high-k materials, they may nevertheless be implemented into the same chip area as a capacitor dielectric, since the capacitor performance is not substantially affected by the deteriorated carrier mobility at the interface between the high-k dielectric and the underlying active region.

According to one illustrative embodiment of the present invention, a semiconductor device comprises a first active semiconductor region and a second active semiconductor region separated from each other by a dielectric isolation structure. A capacitor is formed in and over the first active semiconductor region with a first dielectric layer formed on the first active region, wherein the first dielectric layer has a first permittivity. Moreover, a field effect transistor is formed in and on the second active semiconductor region, wherein the field effect transistor includes a gate insulation layer comprising a material having a second permittivity that is less than the first permittivity.

According to yet another illustrative embodiment of the present invention, a semiconductor device comprises a first capacitive element formed in and on a first semiconductor region and a second capacitive element formed in and on a second active region. The first and the second capacitive elements comprise, respectively, a first dielectric layer having a first thickness and a second dielectric layer having a second thickness, and a first conductive layer formed on the first dielectric layer and a second conductive layer formed on the second dielectric layer. Additionally, a capacitance per unit area of the first capacitive element is equal or higher than that of the second capacitive element, wherein the second thickness is less than the first thickness.

According to still another illustrative embodiment of the present invention, a method of forming a semiconductor device comprises providing a substrate having formed thereon a first semiconductor region and a second semiconductor region separated by an isolation structure. Moreover, a first dielectric layer having a first permittivity and a first thickness is formed on the first semiconductor region. Additionally, a second dielectric layer having a second permittivity and a second thickness is formed on the second semiconductor region. Additionally, a conductive material is formed on the first and the second dielectric layers to create a first and a second capacitive element, wherein the first permittivity is higher than the second permittivity.

In accordance with yet a further illustrative embodiment of the present invention, a method of fabricating a semiconductor device including a field effect transistor element and a passive capacitor comprises defining a first active region and a second active region by forming shallow trench isolations. Furthermore, a first dielectric layer is formed on the first semiconductor region as a capacitor dielectric and a second dielectric layer is formed on the second active region as a gate insulation layer of the field effect transistor element. Moreover, a permittivity of the first dielectric layer is higher than that of the second dielectric layer.

### BRIEF DESCRIPTION OF THE DRAWINGS

The invention may be understood by reference to the following description taken in conjunction with the accompanying drawings, in which like reference numerals identify like elements, and in which:
Figures 1a-1c schematically show cross-sectional views of a semiconductor device including a passive capacitor and a transistor element that are fabricated in accordance with a typical prior art process flow; and
Figures 2a-2g schematically show cross-sectional views of a semiconductor device including a low leakage capacitor having an increased capacitance per unit area, which is formed in accordance with one illustrative embodiment of the present invention.

While the invention is susceptible to various modifications and alternative forms, specific embodiments thereof have been shown by way of example in the drawings and are herein described in detail. It should be understood, however, that the description herein of specific embodiments is not intended to limit the invention to the particular forms disclosed, but on the contrary, the intention is to cover all modifications, equivalents, and alternatives falling within the spirit and scope of the invention as defined by the appended claims.

### MODE(S) FOR CARRYING OUT THE INVENTION

Illustrative embodiments of the invention are described below. In the interest of clarity, not all features of an actual implementation are described in this specification. It will of course be appreciated that in the development of any such actual embodiment, numerous implementation-specific decisions must be made to achieve the developers' specific goals, such as compliance with system-related and business-related constraints, which will vary from one implementation to another. Moreover, it will be appreciated that such a development effort might be complex and time-consuming, but would nevertheless be a routine undertaking for those of ordinary skill in the art having the benefit of this disclosure.

The present invention will now be described with reference to the attached figures. Although the various regions and structures of a semiconductor device are depicted in the drawings as having very precise, sharp configurations and profiles, those skilled in the art recognize that, in reality, these regions and structures are not as precise as indicated in the drawings. Additionally, the relative sizes of the various features and doped regions depicted in the drawings may be exaggerated or reduced as compared to the size of those features or regions on fabricated devices. Nevertheless, the attached drawings are included to describe and explain illustrative examples of the present invention. The words and phrases used herein should be understood and interpreted to have a meaning consistent with the understanding of those words and phrases by those skilled in the relevant art. No special definition of a term or phrase, i.e., a definition that is different from the ordinary and customary meaning as understood by those skilled in the art, is intended to be implied by consistent usage of the term or phrase herein. To the extent that a term or phrase is intended to have a special meaning, i.e., a meaning other than that understood by skilled artisans, such a special definition will be expressly set forth in the specification in a definitional manner that directly and unequivocally provides the special definition for the term or phrase.

With reference to Figures 2a-2g, illustrative embodiments of the present invention will now be described in more detail. In Figure 2a, a semiconductor device 200 comprises a substrate 201, which may be any appropriate substrate, such as a silicon substrate, a glass substrate, a sapphire substrate, an SOI (silicon on insulator) substrate and the like. Irrespective of the specific type used, the substrate 201 comprises a first semiconductor region 220 and a second semiconductor region 230 that are substantially isolated from each other by an isolation structure 202, such as a shallow trench isolation as is usually used in highly sophisticated circuits. On top of the semiconductor device 200, a first dielectric layer 221 is formed having a first thickness 222. The first dielectric layer 221 is formed of a material exhibiting a high permittivity represented by a high dielectric constant k. Materials that may be suitably employed in the first dielectric layer 221 include, without limiting the present invention to these materials, zirconium oxide and/or zirconium silicate and/or hafnium oxide and/or hafnium silicate. Compared to the commonly-employed silicon dioxide, possibly including a certain amount of nitrogen, the k value may be at least twice as high or even more for these materials. The exact value of the permittivity may depend on the deposition parameters so that the first thickness 222 is selected in conformity with deposition parameters so as to achieve the required final capacitive coupling of the capacitor to be formed in and over the first semiconductor region 220. In addition, the first thickness 222 is selected to conform with the desired resistance against leakage current so that, commonly, an optimum value is determined to provide for a given dielectric material exhibiting a specified permittivity, a high capacitance per unit area while maintaining the leakage current beyond a specified threshold. In one illustrative embodiment, where zirconium oxide is selected as the material for the first dielectric layer 221, the thickness 222 may range from approximately 3-15 nm.

A typical process flow for forming the semiconductor device 200 as depicted in Figure 2a may include well-known photolithography and etch techniques for forming the isolation structures 202 and well-known and well-established deposition methods for forming the first dielectric layer 221. Accordingly, a detailed description of these process steps is omitted.

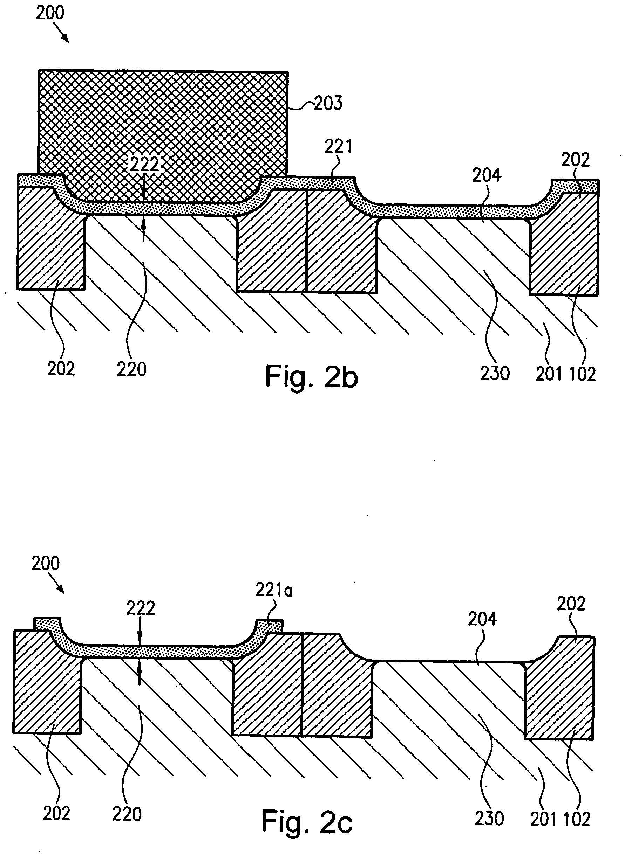

Figure 2b schematically shows the semiconductor device 200 with a resist mask 203 formed over the first semiconductor region 220 and partially over the corresponding isolation structure 202. The resist mask 203 is to cover both areas of the first semiconductor regions 220 and the isolation structures 202, which will be used for forming a capacitive element, such as a de-coupling capacitor and the like. The formation of the resist mask 203 involves well known photolithography techniques, which for the sake of simplicity are not described in detail herein. Subsequently, the first dielectric layer 221 is patterned by subjecting the substrate 201 to a selective etch process, which may be performed as an isotropic or an anisotropic etch process.
Figure 2c schematically shows the semiconductor device 200 after patterning the first dielectric layer 221 to form a capacitor dielectric 221a and after removing the photoresist mask 203. Subsequently, the substrate 201 is cleaned to remove any residuals from the previous process steps, thereby preparing the second semiconductor region 230 to receive a dielectric layer that will serve as a gate insulation layer for a field effect transistor to be formed.

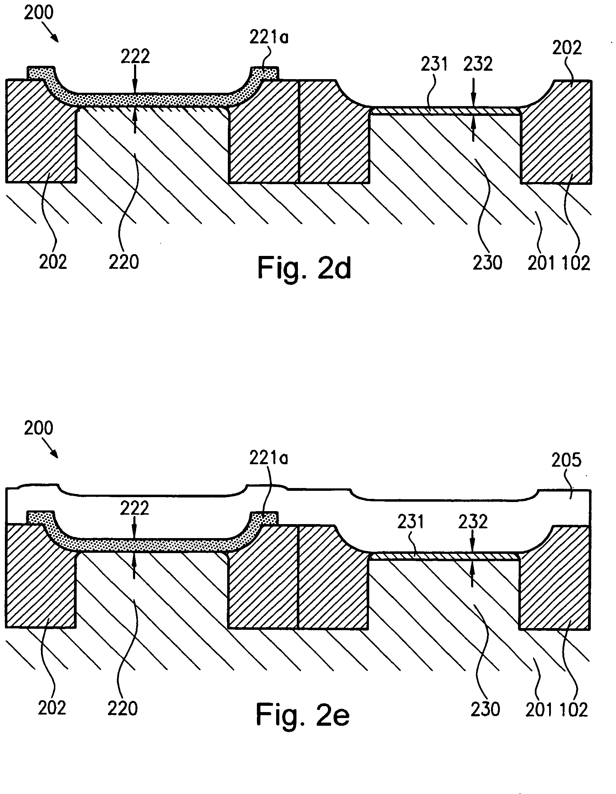

Figure 2d schematically depicts the semiconductor device 200 with a second dielectric layer 231 having a thickness 232, which is formed on the second semiconductor region 230. The second dielectric layer 231 exhibits characteristics that comply with the specifications for a gate insulation layer of the highly sophisticated field effect transistor. For instance, the second dielectric layer 231 may be comprised of silicon dioxide or silicon oxynitride with the thickness 232 selected to ensure a sufficient capacitive coupling of a gate electrode to be formed to the underlying second semiconductor region 230. For example, the second thickness 232 may be selected in the range of approximately 1-5 nm, depending on the design requirements for the field effect transistor to be formed.

In one embodiment (not shown), a thin barrier layer may be formed on the capacitor dielectric 221a prior to the formation of the second dielectric layer 231. For example, a thin silicon nitride layer may be deposited on the semiconductor device 200 and may then be selectively removed from the second semiconductor region 230 prior to the formation of the second dielectric layer 231. In a further embodiment, a thin silicon nitride layer or any other appropriate barrier layer may be provided prior to the formation of the first dielectric layer 221 (Figure 2a) so that, in combination with an additional barrier layer covering the surface portions of the capacitor dielectric 221 a, the high-k dielectric may be substantially completely enclosed by a thin barrier layer. Process techniques for precisely depositing silicon nitride, for example, are well established in the art and may be advantageously used for "wrapping" or covering the capacitor dielectric 221 a.

Regarding the formation of the second dielectric layer 231, any appropriate process may be employed, including advanced furnace processes, such as conventional oxidation or rapid thermal oxidation. For highly sophisticated semiconductor devices requiring ultra thin gate insulation layers on the order of 2-3 nm, alternative oxide and oxynitride deposition schemes may be employed for providing the required second thickness 232. Advantageously, when the capacitor dielectric 221a is covered or substantially completely enclosed by a thin barrier layer, "cross contamination" between the first and the second semiconductor regions 220, 230 may be substantially avoided, irrespective of the process used for forming the second dielectric layer 231.
Figure 2e schematically shows the semiconductor device 200 with a layer 205 of gate electrode material deposited over the substrate 201. In one typical embodiment, the layer 205 may be substantially comprised of polysilicon. In other embodiments, any other suitable materials, such as metal silicide or a metal, may be used. Subsequently, the layer 205 is patterned by well-established photolithography and etching techniques so that the corresponding process steps will not be described herein.

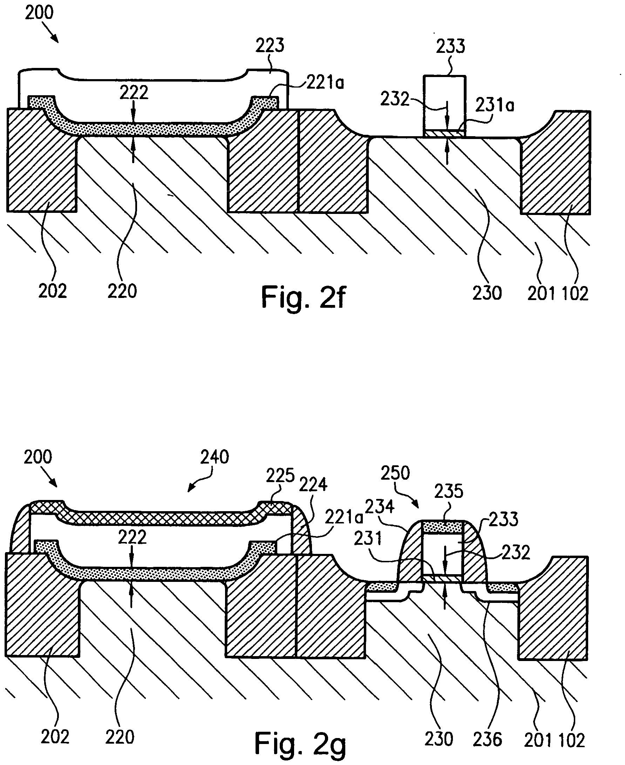

Figure 2f shows the semiconductor device 200 after patterning the layer 205 to obtain a gate electrode 233 formed on the patterned second dielectric layer 231, which is indicated as 231a and which will be referred to as the gate insulation layer. Over the capacitor dielectric 221a and partially on the respective isolation structures 202, the layer 205 has been patterned into a capacitor electrode 223. Subsequently, the conventional process flow for completing a field effect transistor may be carried out as is, for example, described with reference to Figure 1c.
Figure 2g shows the resulting semiconductor device 200 after conventional spacer, implant and self-aligned silicide processing to obtain a transistor element 250 and a capacitor 240. The transistor element 250 comprises metal silicide portions 235 formed in the upper portions of the gate electrode 233 and of drain and source regions 236. Moreover, sidewall spacers 234 are formed adjacent to sidewalls of the gate electrode 233. Similarly, the capacitor 240 comprises sidewall spacers 224 and a metal silicide portion 225. It should be noted that contact portions, such as the metal silicide portions 235 located on the drain and source regions 236, for the capacitor 240 are not depicted in the cross-sectional views of Figures 2f and 2g, since these contact portions are located at a different position with respect to a direction perpendicular to the drawing plane of Figures 2a-2g.

As a result, the embodiments described above provide a semiconductor device including capacitive elements, such as the combination of the gate electrode 233, the gate insulation layer 231 a and the underlying active region 230, and the capacitor 240 formed by the capacitor electrode 223, the capacitor dielectric 221 a and the underlying first semiconductor region 220, wherein the capacitive elements both exhibit a required high capacitance per unit area. While the gate insulation layer 231a is optimized to provide for a high capacitive coupling of the gate electrode 233 to the second active region 230 for sufficient channel control without unduly affecting the carry mobility at the interface between the gate insulation layer 231a and the active region 230, the capacitive coupling between the capacitor electrode 223 and the first semiconductor region 220 is optimized by introducing a high-k material, wherein the first thickness 222 is selected to provide for a required low leakage current. Consequently, capacitors of high capacitance with reduced leakage current may be provided in combination with highly sophisticated transistor elements requiring ultra thin gate insulation layers for sufficient carrier mobility on the same chip area, while reliability of the capacitor dielectric is ensured due to the omission of any destructive implantation steps, as for example required in the prior art processing, and due to the relatively large thickness 222. Moreover, as is evident from Figures 2a-2g, any appropriate technique may be used for forming the ultra thin gate insulation layer 231a so that sophisticated deposition and patterning processes may be employed instead of a high temperature oxidation. Moreover, since the capacitance per unit area of the capacitor 240 is significantly increased compared to prior art devices while, at the same time, leakage current is decreased and thus power consumption of the semiconductor device is decreased, the overall area of the chip required for providing a desired functionality may be reduced. Since less heat is created per unit area, integrated circuits including semiconductor devices in accordance with the present invention also significantly relax the issue of sufficient device cooling, thereby allowing the installation of less cool capacity, which also contributes to a significant reduction of power consumption, especially in portable devices.

The particular embodiments disclosed above are illustrative only, as the invention may be modified and practiced in different but equivalent manners apparent to those skilled in the art having the benefit of the teachings herein. For example, the process steps set forth above may be performed in a different order. Furthermore, no limitations are intended to the details of construction or design herein shown, other than as described in the claims below. It is therefore evident that the particular embodiments disclosed above may be altered or modified and all such variations are considered within the scope as set forth in the claims.

## Claims

1. A semiconductor device comprising:
a substrate (201) comprising a first semiconductor region (220) and a second semiconductor region (230) separated from each other by a dielectric isolation structure (202);
a capacitor (240) formed in and over said first semiconductor region (220), the capacitor (240) including a high-k dielectric (221A) formed on the surface of the substrate (201) on said first semiconductor region (220), said dielectric (221A) having a first permittivity; and
a field effect transistor (250) formed in and over said second semiconductor region (230), said field effect transistor (250) including a gate insulation layer (231) formed of a material having a second permittivity that is less than said first permittivity.

2. The semiconductor device of claim 1, wherein said dielectric (221A) of the capacitor (240) comprises at least one of zirconium oxide, zirconium silicate, hafnium oxide and hafnium silicate.

3. The semiconductor device of claim 1, wherein said dielectric (221A) of said capacitor (240) includes one or more sub layers.

4. The semiconductor device of claim 1, further comprising a barrier layer disposed between said first semiconductor region (220) and said dielectric (221A) of said capacitor (240).

5. The semiconductor device of claim 1, further comprising a barrier layer substantially completely covering surface portions of said dielectric (221A).

6. A semiconductor device comprising:
a substrate (201) comprising a first semiconductor region (220) and a second semiconductor region (230) separated from each other by a dielectric isolation structure (202);
a first capacitive element formed in and on said first semiconductor region (220) and comprising a first high-k dielectric (221A) formed on the surface of the substrate (201) on said first semiconductor region (220); and
a second capacitive element formed in and on said second semiconductor region (230), said first dielectric (221A) disposed between said first semiconductor region (220) and a first conductive layer and having a first thickness (222), said second capacitive element comprising a second dielectric (231) disposed between said second semiconductor region (230) and a second conductive layer and having a second thickness (232);
wherein a capacitance per unit area of said first capacitive element is equal or higher than that of said second capacitive element, while said second thickness (232) is less than said first thickness (222).

7. The semiconductor device of claim 6, wherein said first dielectric (221A) comprises at least one of zirconium oxide, zirconium silicate, hafnium oxide and hafnium silicate.

8. The semiconductor device of claim 6, further comprising a barrier layer disposed between said first semiconductor region (220) and said first dielectric (221A).

9. The semiconductor device of claim 6, further comprising a barrier layer substantially completely covering surface portions of said first dielectric (221A).

10. A method of forming a semiconductor device, the method comprising:
providing a semiconductor substrate (201) having formed therein a first semiconductor region (220) and a second semiconductor region (230) separated by an isolation structure (202) formed in the semiconductor substrate (201);
forming a first high-k dielectric layer (221A) having a first permittivity with a first thickness (222) on the surface of the substrate (201) on said first semiconductor region (220);
forming a second dielectric layer (231) having a second permittivity with a second thickness (232) on said second semiconductor region (230); and
patterning a layer of conductive material (205) formed on said first and said second dielectric layers to create a first capacitor and a second capacitor , wherein said first permittivity is higher than said second permittivity.

11. The method of claim 10, wherein said second thickness (232) is less than said first thickness (222).

12. The method of claim 10, wherein forming said first dielectric layer (221A) includes depositing a material having said first permittivity, masking at least said first semiconductor region (220) and removing an unmasked portion of said material.

13. The method of claim 12, wherein depositing said material having the first permittivity includes depositing a barrier layer and depositing a bulk material so that the barrier layer in combination with the bulk material exhibits the first permittivity.

14. The method of claim 10, further comprising forming a cap layer on exposed portions of said first dielectric layer (221A) prior to forming said second dielectric layer (231).

15. A method of fabricating a semiconductor device including a field effect transistor element (250) and a passive capacitor (240), the method comprising:
defining a first semiconductor region (220) and a second semiconductor region (230) by forming an isolation structure (202) in a semiconductor region of a substrate (201);
forming a first high-k dielectric layer (221A) on the surface of the substrate (201) on said first semiconductor region (220) to serve as a capacitor dielectric, wherein said first high-k dielectric layer is formed on the semiconductor device and subsequently patterned by subjecting the substrate to a selective etch process; and
forming a second dielectric layer (231) on said second semiconductor region (230) serving as a gate insulation layer of said field effect transistor (250);
wherein a permittivity of said first dielectric layer (221A) is higher than that of said second dielectric layer (231).

16. The method of claim 15, wherein a thickness (232) of said second dielectric layer (231) is less than a thickness (222) of said first dielectric layer (221A).

17. The method of claim 15, wherein forming said first dielectric layer (221A) includes depositing a material having said first permittivity, masking at least said first semiconductor region (220) and removing an unmasked portion of said material.

18. The method of claim 15, wherein depositing said material having said first permittivity includes depositing a barrier layer and depositing a bulk material such that said barrier layer in combination with said bulk material exhibits said first permittivity.

19. The method of claim 15, further comprising forming a layer (205) of gate electrode material and patterning said layer (205) of gate electrode material to form a gate electrode (233) of said field effect transistor (250) and an electrode (223) of said capacitor (240).

## Patentansprüche

1. Halbleiterbauelement mit:
einem Substrat (201) mit einem ersten Halbleiterbereich (220) und einem zweiten Halbleiterbereich (230), die voneinander durch eine dielektrische Isolationsstruktur (202) getrennt sind;
einem Kondensator (240), der in und über dem ersten Halbleiterbereich (220) gebildet ist, wobei der Kondensator ein Dielektrikum (221A) mit großem ε aufweist, das auf der Oberfläche des Substrats (201) auf dem ersten Halbleiterbereich (220) gebildet ist und wobei das Dielektrikum (221A) eine erste Permittivität besitzt; und
einem Feldeffekttransistor (250), der in und über dem zweiten Halbleiterbereich (230) gebildet ist, wobei der Feldeffekttransistor (250) eine Gateisolationsschicht (231) aufweist, die aus einem Material mit einer zweiten Permittivität, die kleiner als die erste Permittivität ist, gebildet ist.

2. Das Halbleiterbauelement nach Anspruch 1, wobei das Dielektrikum (221A) des Kondensators (240) Zirkonoxid und/oder Zirkonsilikat und/oder Hafniumoxid und/oder Hafniumsilikat aufweist.

3. Das Halbleiterbauelement nach Anspruch 1, wobei das Dielektrikum (221A) des Kondensators (240) eine oder mehrere Teilschichten aufweist.

4. Das Halbleiterbauelement nach Anspruch 1, das ferner eine Barrierenschicht aufweist, die zwischen dem ersten Halbleiterbereich (220) und dem Dielektrikum (221A) des Kondensators (240) angeordnet ist.

5. Das Halbleiterbauelement nach Anspruch 1, das ferner eine Barrierenschicht aufweist, die im Wesentlichen vollständig Oberflächenbereiche des Dielektrikums (221 A) bedeckt.

6. Halbleiterbauelement mit:
einem Substrat (201), das ein erstes Halbleitergebiet (220) und ein zweites Halbleitergebiet (230) aufweist, die voneinander durch eine dielektrische Isolationsstruktur (202) getrennt sind;
einem ersten kapazitiven Element, das in und auf dem ersten Halbleitergebiet (220) gebildet ist und ein erstes Dielektrikum (221A) mit großem ε aufweist, das auf der Oberfläche des Substrats (201) auf dem ersten Halbleiterbereich (220) gebildet ist;
einem zweiten kapazitiven Element, das in und auf dem zweiten Halbleitergebiet (230) gebildet ist, wobei das erste Dielektrikum (221A) zwischen dem ersten Halbleitergebiet (220) und einer ersten leitenden Schicht angeordnet ist und eine erste Dicke (222) aufweist, und das zweite kapazitive Element ein zweites Dielektrikum (231) aufweist, das zwischen dem zweiten Halbleitergebiet (230) und einer zweiten leitenden Schicht angeordnet ist und eine zweite Dicke (232) aufweist,
wobei eine Kapazität pro Einheitsfläche des ersten kapazitiven Elements gleich oder größer als jene des zweiten kapazitiven Elements ist, wobei die zweite Dicke (232) kleiner als die erste Dicke (222) ist.

7. Das Halbleiterelement nach Anspruch 6, wobei das erste Dielektrikum (221A) Zirkonoxid und/oder Zirkonsilikat und/oder Hafniumoxid und Hafniumsilikat aufweist.

8. Das Halbleiterbauelement nach Anspruch 6, das ferner eine Barrierenschicht aufweist, die zwischen dem ersten Halbleitergebiet (220) und dem ersten Dielektrikum (221A) angeordnet ist.

9. Das Halbleiterbauelement nach Anspruch 6, das ferner eine Barrierenschicht aufweist, die im Wesentlichen vollständig Oberflächenbereiche des ersten Dielektrikums (221A) bedeckt.

10. Verfahren zum Bilden eines Halbleiterbauelements, wobei das Verfahren umfasst:
Bereitstellen eines Halbleitersubstrats (201) mit einem darin ausgebildeten ersten Halbleitergebiet (220) und einem zweiten Halbleitergebiet (230), die durch eine Isolationsstruktur (202), die in dem Halbleitersubstrat (201) gebildet ist, getrennt sind;
Bilden einer ersten dielektrischen Schicht mit Material mit großem ε (221 A) mit einer ersten Permittivität mit einer ersten Dicke (222) auf der Oberfläche des Substrats (201) auf dem ersten Halbleitergebiet (220);
Bilden einer zweiten dielektrischen Schicht (231) mit einer zweiten Permittivität mit einer zweiten Dicke (232) auf dem zweiten Halbleitergebiet (230); und
Strukturieren einer Schicht aus leitendem Material (205), die auf der ersten und auf der zweiten dielektrischen Schicht gebildet ist, um einen ersten Kondensator und einen zweiten Kondensator zu schaffen, wobei die erste Permittivität größer als die zweite Permittivität ist.

11. Das Verfahren nach Anspruch 10, wobei die zweite Dicke (232) kleiner als die erste Dicke (222) ist.

12. Das Verfahren nach Anspruch 10, wobei das Bilden der ersten dielektrischen Schicht (221A) umfasst: Abscheiden eines Materials mit der ersten Permittivität, Maskieren zumindest des ersten Halbleitergebiets (220) und Entfernen eines unmaskierten Bereichs des Materials.

13. Das Verfahren nach Anspruch 12, wobei Abscheiden des Materials mit der ersten Permittivität das Abscheiden einer Barrierenschicht und das Abscheiden eines Volumenmaterials mit einschließt, so dass die Barrierenschicht in Kombination mit dem Volumenmaterial die erste Permittivität besitzt.

14. Das Verfahren nach Anspruch 10, das ferner Bilden einer Deckschicht auf freigelegten Bereichen der ersten dielektrischen Schicht (221A) vor dem Bilden der zweiten dielektrischen Schicht (231) umfasst.

15. Verfahren zur Herstellung eines Halbleiterbauelements mit einem Feldeffekttransistorelement (250) und einem passiven Kondensator (240), wobei das Verfahren umfasst:
Definieren eines ersten Halbleitergebiets (220) und eines zweiten Halbleitergebiets (230) durch Bilden einer Isolationsstruktur (202) in einem Halbleitergebiet eines Substrates (201);
Bilden einer ersten dielektrischen Schicht (221A) mit Material mit großem ε auf dem ersten Halbleitergebiet (220), um als ein Kondensatordielektrikum zu dienen, wobei die erste dielektrische Schicht mit Material mit großem ε auf dem Halbleiterbauelement gebildet ist und anschließend strukturiert wird, indem das Substrat einem selektiven Ätzprozess ausgesetzt wird;
Bilden einer zweiten dielektrischen Schicht (231) auf dem zweiten Halbleitergebiet (230), die als eine Gateisolationsschicht des Feldeffekttransistors (250) dient,
wobei eine Permittivität der ersten dielektrischen Schicht (221A) höher ist als jene der zweiten dielektrischen Schicht (231).

16. Das Verfahren nach Anspruch 15, wobei eine Dicke (232) der zweiten dielektrischen Schicht (231) kleiner als eine Dicke (222) der ersten dielektrischen Schicht (221A) ist.

17. Das Verfahren nach Anspruch 15, wobei Bilden der ersten dielektrischen Schicht (221A) Abscheiden eines Materials mit der ersten Permittivität, Maskieren zumindest des ersten Halbleitergebiets (220) und Entfernen eines unmaskierten Bereichs des Materials umfasst.

18. Das Verfahren nach Anspruch 15, wobei Abscheiden des Materials mit der ersten Permittivität umfasst: Abscheiden einer Barrierenschicht und Abscheiden eines Volumenmaterials so, dass die Barrierenschicht in Kombination mit dem Volumenmaterial die erste Permittivität aufweist.

19. Das Verfahren nach Anspruch 15, das ferner Bilden einer Schicht (205) aus Gateelektrodenmaterial und Strukturieren der Schicht (205) aus Gateelektrodenmaterial umfasst, um eine Gateelektrode (233) des Feldeffekttransistors (250) und eine Elektrode (223) des Kondensators (240) zu bilden.

## Revendications

1. Dispositif à semi-conducteur comprenant :
un substrat (201) comprenant une première région semi-conductrice (220) et une seconde région semi-conductrice (230) séparées l'une de l'autre par une structure d'isolation diélectrique (202) ;
un condensateur (240) formé dans et sur ladite première région semi-conductrice (220), le condensateur (240) comprenant un diélectrique à coefficient k élevé (221A) formé sur la surface du substrat (201) sur ladite première région semi-conductrice (220), ledit diélectrique (221A) comprenant une première permittivité ; et
un transistor à effet de champ (250) formé dans et sur ladite seconde région semi-conductrice (230), ledit transistor à effet de champ (250) comprenant une couche d'isolation de grille (231) formée d'un matériau comprenant une seconde permittivité qui est inférieure à ladite première permittivité.

2. Dispositif à semi-conducteur conformément à la revendication 1, dans lequel ledit diélectrique (221A) du condensateur (240) comprend de l'oxyde de zirconium et/ou du silicate de zirconium et/ou de l'oxyde de hafnium et/ou du silicate de hafnium.

3. Dispositif à semi-conducteur conformément à la revendication 1, dans lequel ledit diélectrique (221A) dudit condensateur (240) comprend une ou plusieurs sous-couche(s).

4. Dispositif à semi-conducteur conformément à la revendication 1, comprenant en outre une couche barrière disposée entre ladite première région semi-conductrice (220) et ledit diélectrique (221A) dudit condensateur (240).

5. Dispositif à semi-conducteur conformément à la revendication 1, comprenant en outre une couche barrière couvrant pratiquement entièrement les parties de surface dudit diélectrique (221A).

6. Dispositif à semi-conducteur comprenant :
un substrat (201) comprenant une première région semi-conductrice (220) et une seconde région semi-conductrice (230) séparées l'une de l'autre par une structure d'isolation diélectrique (202) ;
un premier élément capacitif formé dans et sur ladite première région semi-conductrice (220) et comprenant un premier diélectrique à coefficient k élevé (221A) formé sur la surface du substrat (201) sur ladite première région semi-conductrice (220) ; et
un second élément capacitif formé dans et sur ladite seconde région semi-conductrice (230), ledit premier diélectrique (221A) étant disposé entre ladite première région semi-conductrice (220) et une première couche conductrice et présentant une première épaisseur (222), ledit second élément capacitif comprenant un second diélectrique (231) disposé entre ladite seconde région semi-conductrice (230) et une seconde couche conductrice et présentant une seconde épaisseur (232) ;
dans lequel une capacité par surface unitaire dudit premier élément capacitif est égale ou supérieure à celle dudit second élément capacitif, tandis que ladite seconde épaisseur (232) est inférieure à celle de ladite première épaisseur (222).

7. Dispositif à semi-conducteur conformément à la revendication 6, dans lequel ledit premier diélectrique (221A) comprend un oxyde de zirconium et/ou un silicate de zirconium et/ou un oxyde de hafnium et/ou un silicate de hafnium.

8. Dispositif à semi-conducteur conformément à la revendication 6, comprenant en outre une couche barrière disposée entre ladite première région semi-conductrice (220) et ledit premier diélectrique (221A).

9. Dispositif à semi-conducteur conformément à la revendication 6, comprenant en outre une couche barrière recouvrant pratiquement entièrement les parties de surface dudit premier diélectrique (221A).

10. Procédé de formation d'un dispositif à semi-conducteur, comprenant :
la fourniture d'un substrat à semi-conducteur (201) sur lequel sont formées une première région semi-conductrice (220) et une seconde région semi-conductrice (230) séparées par une structure d'isolation (202) formée dans le substrat à semi-conducteur (201) ;
la formation d'une première couche diélectrique à coefficient k élevé (221A) présentant une première permittivité d'une première épaisseur (222) sur la surface du substrat (201) sur ladite première région semi-conductrice (220) ;
la formation d'une seconde couche diélectrique (231) présentant une seconde permittivité d'une seconde épaisseur (232) sur ladite seconde région semi-conductrice (230) ; et
la formation de motif sur une couche de matériau conducteur (205) formée sur lesdites première et seconde couches diélectriques afin de créer un premier condensateur et un second condensateur, ladite première permittivité étant supérieure à ladite seconde permittivité.

11. Procédé conformément à la revendication 10, dans lequel ladite seconde épaisseur (232) est inférieure à ladite première épaisseur (222).

12. Procédé conformément à la revendication 10, dans lequel la formation de ladite première couche diélectrique (221A) comprend le dépôt de matériau présentant ladite première permittivité, l'application d'un masque sur au moins ladite première région semi-conductrice (220) et le retrait d'une partie sans masque dudit matériau.

13. Procédé conformément à la revendication 12, dans lequel le dépôt dudit matériau présentant la première permittivité comprend le dépôt d'une couche barrière et le dépôt d'un matériau en vrac de sorte que la couche barrière en combinaison avec le matériau en vrac présente la première permittivité.

14. Procédé conformément à la revendication 10, comprenant en outre la formation d'une couche d'encapsulation sur des parties découvertes de ladite première couche diélectrique (221A) avant la formation de ladite seconde couche diélectrique (231).

15. Procédé de fabrication d'un dispositif à semi-conducteur comprenant un élément de transistor à effet de champ (250) et un condensateur passif (240), le procédé comprenant :
la définition d'une première région semi-conductrice (220) et d'une seconde région semi-conductrice (230) par la formation d'une structure d'isolation (202) dans une région semi-conductrice d'un substrat (201).
la formation d'une première couche diélectrique à coefficient k élevé (221A) sur la surface du substrat (201) sur ladite première région semi-conductrice (220) pour servir de diélectrique de condensateur, ladite première couche diélectrique à coefficient k élevé étant formée sur le dispositif à semi-conducteur et faisant ensuite l'objet d'une formation de motif par soumission du substrat à un procédé de gravure sélective ; et
la formation d'une seconde couche diélectrique (231) sur ladite région semi-conductrice (230) servant de couche d'isolation de grille du transistor à effet de champ (250) ;
une permittivité de ladite première couche diélectrique (221A) étant supérieure à celle de ladite seconde couche diélectrique (231).

16. Procédé conformément à la revendication 15, dans lequel une épaisseur (232) de ladite seconde couche diélectrique (231) est inférieure à une épaisseur (222) de ladite première couche diélectrique (221A).

17. Procédé conformément à la revendication 15, dans lequel la formation de ladite première couche diélectrique (221A) comprend le dépôt d'un matériau présentant ladite première permittivité, l'application d'un masque sur au moins ladite première région semi-conductrice (220) et le retrait d'une partie sans masque dudit matériau.

18. Procédé conformément à la revendication 15, dans lequel le dépôt dudit matériau présentant ladite première permittivité comprend le dépôt d'une couche barrière et le dépôt d'un matériau en vrac de sorte que ladite couche barrière en combinaison avec ledit matériau en vrac présente ladite première permittivité.

19. Procédé conformément à la revendication 15, comprenant en outre la formation d'une couche (205) de matériau d'électrode de grille et la formation de motif sur ladite couche (205) de matériau d'électrode de grille afin de former une électrode de grille (233) dudit transistor à effet de champ (250) et une électrode (223) dudit condensateur (240).
